# EUROPÄISCHE PATENTSCHRIFT

(11) **EP 2 716 143 B1**
(45) Veröffentlichungstag und Bekanntmachung des Hinweises auf die Patenterteilung: **04.09.2019**
(21) Anmeldenummer: 12728963.5
(22) Anmeldetag: 23.05.2012
(51) Int. Cl.: H05K 1/02, H01F 27/28, H05K 1/16, H05K 3/20

(54) **LEITERPLATTE MIT FORMTEIL UND VERFAHREN ZU DESSEN HERSTELLUNG**
PRINTED CIRCUIT BOARD HAVING A MOLDED PART AND METHOD FOR THE PRODUCTION THEREOF
CARTE DE CIRCUIT IMPRIMÉ À PIÈCE MOULÉE ET SON PROCÉDÉ DE FABRICATION

(30) Priorität: 24.05.2011 DE 102011102484
(43) Veröffentlichungstag der Anmeldung: 09.04.2014
(73) Patentinhaber: JUMATECH GmbH, 90542 Eckental (DE)
(72) Erfinder: WÖLFEL, Markus, 91207 Lauf (DE)
(74) Vertreter: Grünecker Patent- und Rechtsanwälte PartG mbB
(86) Internationale Anmeldenummer: PCT/EP2012/002205
(87) Internationale Veröffentlichungsnummer: WO 2012/159753

(56) Entgegenhaltungen:
- EP-A1- 1 737 282
- EP-A2- 0 961 303
- WO-A1-01/91142
- WO-A1-2007/087982
- WO-A1-2011/010491
- DE-A1- 10 234 081
- DE-U1- 29 622 729
- JP-A- H09 219 326

## Beschreibung

Die Erfindung betrifft eine Leiterplatte zur Anwendung im Bereich der Leistungselektronik mit einem Formteil sowie ein Verfahren zu dessen Herstellung. Der Begriff Leistungselektronik umschreibt im Allgemeinen das Teilgebiet der Elektrotechnik, welches die Umformung elektrischer Energie mit elektronischen Bauelementen zum Gegenstand hat. Unter dem Begriff Schaltungs- oder Steuerelektronik versteht man im Allgemeinen dagegen im Wesentlichen die Nutzung elektrischer Leistung nur zur Signal- und Datenverarbeitung.

Eine solche Leiterplatte umfasst üblicherweise geätzte Leiterbahnen und/oder Leitungsdrähte. Der Begriff Leiterplatte im Sinne dieser Erfindung bezieht sich demnach auf eine Leiterplatte oder Platine, die geätzte Leiterbahnen und/oder Leitungsdrähte umfassen kann.

Üblicherweise werden die Leiterbahnen durch das Ätzverfahren hergestellt, d.h. von einer auf einer Trägerplatte aufgebrachten Kupferfolie werden zwischen den gewünschten Leiterbahnen liegende Bereiche abgeätzt. Bei drahtbeschriebenen Leiterplatten oder Platinen werden hingegen Leitungsdrähte aus elektrisch leitfähigem Material zwischen auf der Platine angeordneten Anschlussstellen der auf der Platine aufzubringenden elektronischen Bauelemente verlegt und beispielsweise zusammen mit der Platine in Verbundbauweise in einen Block aus Isoliermasse eingegossen. Ein Verfahren zur Herstellung einer solchen drahtbeschriebenen Leiterplatte oder Platine ist beispielsweise aus der DE 196 18 917 C1 bekannt. Ein weiteres Beispiel einer solchen Leiterplatte oder Platine ist beispielsweise aus der WO 2007/87982 bekannt. Eine Leiterplatte gemäß Oberbegriff des Anspruchs 1 ist in der EP 1 737 282 A1 offenbart.

Bei einer Anwendung der Leiterplatte im Bereich der Leistungselektronik sind die zur Handhabung der auftretenden Ströme und Wärmemengen erforderlichen Leitungsquerschnitte mit den herkömmlichen Methoden nur mit großem Aufwand realisierbar. Oft sind thermische Probleme in Form von Überhitzung die Folge. Die herkömmlichen Leiterplatten sind daher i. d. R. auf bestimmte Leistungswerte beschränkt.

Der Erfindung liegt die Aufgabe zugrunde, eine Leiterplatte zur Anwendung im Bereich der Leistungselektronik bereit zu stellen, welche mit vergleichsweise geringem Aufwand herstellbar ist und die im Bereich der Leistungselektronik auftretenden Ströme und Wärmemengen beherrschen kann.

Die Aufgabe wird erfindungsgemäß gelöst durch die Leiterplatte nach Anspruch 1, umfassend wenigstens ein sich auf und/oder in der Leiterplatte erstreckendes, plattenförmiges Formteil aus einem elektrisch leitenden Werkstoff. Durch dieses plattenförmige Formteil können mit vergleichsweise geringem Aufwand die erforerforderlichen Leitungsquerschnitte zur Beherrschung der im Bereich der Leistungselektronik auftretenden Ströme und Wärmemengen erzeugt werden.

Als Formteil im Sinne dieser Erfindung wird vorzugsweise ein Bauteil bezeichnet, das in einem Trennverfahren hergestellt ist, in welchem die Form eines Werkstücks verändert wird, wobei das Formteil von dem Werkstück abgetrennt wird und die Endform in der Ausgangsform enthalten ist.

Bevorzugte Weiterbildungen der Erfindung sind Gegenstände der Unteransprüche.

Es kann sich als vorteilhaft erweisen, wenn die Leiterplatte wenigstens eine Anschlussstelle für elektronische Bauelemente aufweist. Dadurch können die beim Betrieb der elektronischen Bauelemente auftretenden Ströme und Wärmemengen leicht über die Leiterplatte abgeführt werden.

Es kann sich als hilfreich erweisen, wenn eine Oberseite und/oder eine Unterseite und/oder wenigstens eine der Randseiten des Formteils, vorzugsweise alle Randseiten des Formteils, zumindest abschnittsweise, vorzugsweise vollständig, mit der Isolierstoffmasse bedeckt ist/sind. Dadurch kann das Formteil einerseits sicher in der Leiterplatte integriert werden und andererseits mit dem Isolierstoff zumindest teilweise ummantelt werden, so dass die Gefahr von Kurzschlüssen oder dergleichen durch Kontakt des Formteils mit weiteren elektrisch leitenden Elementen weitgehend verringert werden kann.

Es kann sich als nützlich erweisen, wenn das Formteil einen Magnetkörper zumindest abschnittsweise, vorzugsweise vollumfänglich, umgibt, wobei das Formteil und der Magnetkörper bevorzugt Bestandteile eines Planartransformators bilden. Ein solcher Planartransformator wird vor allem in der Leistungselektronik bei Übertragungsleistungen zwischen 200 und 5000 Watt eingesetzt. Die Wicklungen des Planartransformators bestehen vorzugsweise aus mehreren entsprechend geformten Formteilen, die durch Isolierstoff getrennt sind. Vorzugsweise wird ein Transformatorkern in Gestalt eines quaderförmigen Ferrit- oder Mu-Metall-Magnetkörpers von der Oberseite der Leiterplatte in eine Öffnung der Leiterplatte eingesetzt. Zur Verringerung von Wirbelströmen kann der Magnetkörper gesintert sein. Der Magnetkörper weist beispielsweise eine Dicke von 3,2 mm auf. Zur Erreichung eines bestimmten Übersetzungsverhältnisses können mehrere Transformatoren je nach Bedarf in Reihe oder parallel geschaltet werden. Dadurch können sich auch die thermischen und die Hochfrequenzeigenschaften weiter verbessern.

Es kann sich als praktisch erweisen, wenn die Leiterplatte mehrere Schichten mit jeweils wenigstens einem Formteil aufweist, wobei die Formteile in den mehreren Schichten vorzugsweise identisch ausgebildet sind und bevorzugt in einer Richtung senkrecht zur Oberseite der Leiterplatte genau oder spiegelverkehrt übereinander liegen, wobei sich vorzugsweise eine Öffnung ausgehend von der Oberseite und/oder der Unterseite der Leiterplatte durch mehrere Schichten in die Leiterplatte erstreckt, wobei der Magnetkörper besonders bevorzugt in dieser Öffnung angeordnet ist. Durch diese Schichtbauweise kann auf besonders kompaktem Bauraum eine hohe Leistungsdichte erzielt werden. In einer vorteilhaften Ausführung liegt die Oberseite oder Unterseite des Magnetkörpers im Wesentlichen in einer Ebene mit der Oberseite oder Unterseite der Leiterplatte und/oder schließt bündig mit der Oberseite oder Unterseite der Leiterplatte ab.

In einer bevorzugten Ausführung der Erfindung erfüllt das wenigstens eine Formteil wenigstens eine der folgenden Anforderungen:
- Das Formteil erstreckt sich im Wesentlichen in einer Ebene.
- Das Formteil besteht aus Metall, vorzugsweise aus Kupfer.
- Das Formteil ist zumindest abschnittsweise, vorzugsweise vollständig, in der Leiterplatte eingebettet.
- Die Oberseiten der Leiterplatte und des Formteils sind im Wesentlichen parallel zueinander ausgerichtet.
- Die Oberseiten der Leiterplatte und des Formteils liegen in einer Ebene und gehen vorzugsweise bündig ineinander über.
- Das Formteil ist aus einem plattenförmigen Werkstück herausgetrennt, vorzugsweise durch Stanzen, Erodieren oder Scheiden, bevorzugt durch Wasserstrahlschneiden.
- Das Formteil weist eine Dicke im Bereich von 10 bis 2000 µm, vorzugsweise im Bereich von 100 bis 1000 µm, bevorzugt im Bereich von 200 bis 500 µm auf.
- Eine Länge und/oder Breite des Formteils ist wenigstens fünfmal, vorzugsweise wenigstens zehnmal, bevorzugt wenigstens zwanzigmal, bevorzugt wenigstens fünfzigmal oder bevorzugt wenigstens hundertmal so groß wie die Dicke des Formteils und/oder die Dicke der Leiterplatte.
- Das Formteil umfasst einen im Wesentlichen rechteckförmigen Querschnitt.
- Die Querschnittsform des Formteils variiert über die Breite und/oder über die Länge des Formteils.
- Die Dicke des Formteils ist über dessen gesamte Fläche konstant.
- Das Formteil umfasst eine Krümmung in einer, zwei, drei oder mehr Krümmungsebenen.
- Das Formteil steht zumindest abschnittsweise aus dem Substrat der Leiterplatte hervor.
- Das Formteil ist nicht im Strangpressverfahren herstellbar oder hergestellt.
- Das Formteil umfasst wenigstens eine Ausnehmung, die ausgehend von einer Randseite des Formteils in das Formteil eingearbeitet ist.
- Das Formteil umfasst wenigstens eine Öffnung, die sich von der Oberseite, der Unterseite oder einer Randseite des Formteils abschnittsweise in das Formteil erstreckt, wobei die Öffnung vorzugsweise zumindest im Bereich ihrer Mündung einen kreisförmigen, ovalen, polygonalen, vorzugsweise dreieckigen, viereckigen, fünfeckigen, bevorzugt rechteckigen oder quadratischen Umriss umfasst, wobei die Öffnung bevorzugt im Wesentlichen nutförmig ausgebildet ist und sich kontinuierlich oder diskontinuierlich entlang einer geraden oder gekrümmten Linie erstreckt, wobei diese Linie besonders bevorzugt zumindest abschnittsweise parallel zu einer Randseite des Formteils verläuft, wobei die Öffnung besonders bevorzugt zumindest abschnittsweise mit Isolierstoffmasse befüllt ist.
- Das Formteil umfasst wenigstens einen Durchbruch, der sich quer, vorzugsweise senkrecht, zur Oberseite, zur Unterseite oder einer Randseite des Formteils durch das Formteil erstreckt, wobei der Durchbruch vorzugsweise einen kreisförmigen, ovalen, polygonalen, vorzugsweise dreieckigen, viereckigen, fünfeckigen, rechteckigen oder quadratischen Umriss umfasst, wobei der Durchbruch bevorzugt im Wesentlichen schlitzförmig ausgebildet ist und sich kontinuierlich oder diskontinuierlich entlang einer geraden oder gekrümmten Linie erstreckt, wobei diese Linie besonders bevorzugt zumindest abschnittsweise parallel zu einer Randseite des Formteils verläuft, wobei der Durchbruch besonders bevorzugt zumindest abschnittsweise mit Isolierstoffmasse befüllt ist.
- Das Formteil ist im Wesentlichen L-förmig, T-förmig, H-förmig, S-förmig, O-förmig, E-förmig, F-förmig, X-förmig, Y-förmig, Z-förmig, C-förmig, U-förmig oder Ω-förmig ausgebildet.
- Mehrere Formteile sind in derselben Ebene oder in verschiedenen Ebenen, vorzugsweise in zueinander parallelen Ebenen innerhalb der Leiterplatte angeordnet.

Das Formteil mit wenigstens einem dieser Merkmale kann besonders einfach hergestellt und in der Leiterplatte integriert werden, so dass die erforderlichen Leitungsquerschnitte zur Beherrschung der im Bereich der Leistungselektronik auftretenden Ströme und Wärmemengen mit besonders geringem Aufwand bewerkstelligt werden können.

In einer vorteilhaften Weiterbildung der Erfindung erfüllt die wenigstens eine Anschlussstelle wenigstens eine der folgenden Anforderungen:
- Die Anschlussstelle ist an der Oberseite der Leiterplatte angeordnet.
- Die Anschlussstelle kontaktiert das Formteil und/oder wenigstens einen Leitungsdraht und/oder wenigstens ein elektronisches Bauelement an jeweils wenigstens einer Kontaktstelle, wobei vorzugsweise mehrere Kontaktstellen in bevorzugt regelmäßigen Abständen voneinander beabstandet sind.
- Das Formteil und/oder wenigstens ein Leitungsdraht ist/sind an einer Unterseite der Anschlussstelle angeordnet.
- Ein elektronisches Bauelement und/oder wenigstens ein Leitungsdraht ist/sind an einer Oberseite der Anschlussstelle angeordnet oder anordenbar.
- Die Kontaktierung an der wenigstens einen Kontaktstelle ist eine Kontaktierung durch Schweißung, Bonden, Löten oder Leitkleben.
- Die Anschlussstelle besteht aus Metall, vorzugsweise aus Kupfer.
- Die Anschlussstelle ist durch Ätzung aus der Folie herausgearbeitet.
- Die Anschlussstelle umfasst eine Dicke im Bereich von 1 bis 200 µm, vorzugsweise im Bereich von 10 bis 100 µm, bevorzugt im Bereich von 20 bis 50 µm.
- Der Umriss der Anschlussstelle entspricht zumindest abschnittsweise oder vollständig dem Umriss des Formteils bei einer Sicht auf die Oberseite der Leiterplatte.
- In wenigstens einem Bereich zwischen der Anschlussstelle und dem Formteil, vorzugsweise in einem Bereich zwischen zwei Kontaktstellen und/oder in einem Bereich, der wenigstens eine Kontaktstelle umgibt, ist eine Isolierstoffmasse angeordnet.
- Mehrere Anschlussstellen stehen über das Formteil und/oder über wenigstens einen Leitungsdraht und/oder über wenigstens eine geätzte Leiterbahn in Verbindung.

Über eine Anschlussstelle mit wenigstens einem dieser Merkmale können die Ströme und Wärmemengen von elektronischen Bauelementen, insbesondere von elektronischen Leistungsbauelementen, besonders gut auf das Formteil übertragen werden.

Es kann von Vorteil sein, wenn auf der Leiterplatte Schaltungselektronik und/oder Leistungselektronik angeordnet ist. Bei dieser Kombination von elektronischen Bauelementen kommen die Vorteile der erfindungsgemäßen Leiterplatte besonders deutlich zur Geltung.

Ein weiterer Aspekt der Erfindung betrifft ein Verfahren zur Herstellung einer Leiterplatte, vorzugsweise einer Leiterplatte nach wenigstens einer der vorangehenden Ausführungen, umfassend die folgenden Schritte:
- Bereitstellen eines plattenförmigen Formteils aus einem elektrisch leitenden Werkstoff;
- Kontaktieren des Formteils mit einer elektrisch leitenden Folie an wenigstens einer Kontaktstelle;
- Aufbringen einer Deckschicht auf die das Formteil kontaktierende Seite der Folie; und
- Herausarbeiten wenigstens einer Anschlussstelle aus der Folie.

Es kann sich als vorteilhaft erweisen, wenn das Verfahren wenigstens eine der folgenden Anforderungen erfüllt:
- Das Bereitstellen des plattenförmigen Formteils erfolgt durch Trennen des Formteils von einem plattenförmigen Werkstück, vorzugsweise durch Stanzen, Erodieren oder Scheiden, bevorzugt Wasserstrahlschneiden.
- Das Kontaktieren des Formteils mit der elektrisch leitenden Folie an der wenigstens einen Kontaktstelle erfolgt durch Schweißung, Bonden, Löten oder Leitkleben, wobei vorzugsweise in wenigstens einem Bereich zwischen der Folie und dem Formteil, bevorzugt in einem Bereich zwischen zwei Kontaktstellen und/oder in einem Bereich, der wenigstens eine Kontaktstelle umgibt, vorab eine Isolierstoffmasse angeordnet wird, wobei die Isolierstoffmasse besonders bevorzugt auf das Formteil aufgebracht wird.
- Das Aufbringen einer Deckschicht auf die das Formteil kontaktierende Seite der Folie erfolgt durch Verpressen der Seite der Folie mit einem Prepreg aus Isolierstoffmasse.
- Das Herausarbeiten wenigstens einer Anschlussstelle aus der Folie erfolgt durch Ätzung.

Weitere vorteilhafte Weiterbildungen der Erfindung ergeben sich durch Kombinationen der in der Beschreibung, den Ansprüchen und den Figuren offenbarten Merkmale.

### Kurze Beschreibung der Figuren

- Fig. 1: zeigt eine perspektivische Ansicht eines Zwischenprodukts in einem Verfahren zur Herstellung einer erfindungsgemäßen Leiterplatte, wobei der Umriss eines Formteils auf einem plattenförmigen, elektrisch leitenden Werkstück skizziert ist, um das Formteil entlang des Umrisses aus dem Werkstück herauszutrennen.
- Fig. 2: zeigt eine perspektivische Ansicht eines weiteren Zwischenprodukts in dem Verfahren zur Herstellung der erfindungsgemäßen Leiterplatte, wobei das Formteil aus dem plattenförmigen Werkstück herausgetrennt ist.
- Fig. 3: zeigt eine perspektivische Ansicht eines weiteren Zwischenprodukts in dem Verfahren zur Herstellung der erfindungsgemäßen Leiterplatte, wonach das Formteil eine elektrisch leitende Folie an Kontaktstellen kontaktiert.
- Fig. 4: zeigt eine perspektivische Ansicht eines weiteren Zwischenprodukts in dem Verfahren zur Herstellung der erfindungsgemäßen Leiterplatte mit Blickrichtung auf die Unterseite des Zwischenprodukts, wobei die das Formteil kontaktierende Unterseite der Folie mit einer elektrisch isolierenden Deckschicht versehen wird, um das Formteil einzubetten und elektrisch zu isolieren.
- Fig. 5: zeigt eine andere perspektivische Ansicht des Zwischenprodukts gemäß Fig. 4 mit Blickrichtung auf die Oberseite des Zwischenprodukts.
- Fig. 6: zeigt eine perspektivische Ansicht einer Leiterplatte nach dem ersten Ausführungsbeispiel der Erfindung, die nach dem erfindungsgemäßen Verfahren hergestellt ist, wobei eine Anschlussstelle durch Materialabtrag aus der Folie herausgearbeitet ist.
- Fig. 7: zeigt eine perspektivische Ansicht einer mehrschichtigen Leiterplatte mit im Wesentlichen identischem Schichtaufbau nach dem zweiten Ausführungsbeispiel der Erfindung, die nach dem erfindungsgemäßen Verfahren hergestellt ist, wobei ein Magnetkörper in einer sich von der Oberseite durch mehrere Schichten der Leiterplatte erstreckende Öffnung eingesetzt ist.
- Fig. 8: zeigt eine Aufsicht eines alternativen Formteils zur Verwendung in dem Verfahren zur Herstellung der erfindungsgemäßen Leiterplatte, wobei das Formteil kreisförmige und nut- oder schlitzförmige Öffnungen und/oder Durchbrüche aufweist.
- Fig. 9: zeigt eine Aufsicht eines anderen alternativen Formteils zur Verwendung in dem Verfahren zur Herstellung der erfindungsgemäßen Leiterplatte, wobei das Formteil nutförmige Öffnungen aufweist, die kontinuierlich entlang von schleifenförmigen und mehrfach gekrümmten Linien im Wesentlichen parallel zu den Randseiten des Formteils verlaufen.
- Fig. 10: zeigt eine Aufsicht noch eines anderen alternativen Formteils zur Verwendung in dem Verfahren zur Herstellung der erfindungsgemäßen Leiterplatte, wobei das Formteil schlitzförmige Durchbrüche aufweist, die diskontinuierlich entlang von schleifenförmigen und mehrfach gekrümmten Linien im Wesentlichen parallel zu den Randseiten der Formteile verlaufen.

### Detaillierte Beschreibung der bevorzugten Ausführungsbeispiele

Die Erfindung basiert insbesondere auf dem Gedanken, eine Leiterplatte zur Anwendung im Bereich der Leistungselektronik bereit zu stellen, welche mit vergleichsweise geringem Aufwand herstellbar ist und die im Bereich der Leistungselektronik auftretenden Ströme und Wärmemengen beherrschen kann. Durch die Anordnung eines plattenförmigen Formteils aus einem leitenden Werkstoff in und/oder auf der Leiterplatte lassen sich auf gleichem Bauraum größere Leitungsquerschnitte realisieren, was vor allem beim Einsatz von Leistungselektronik von Vorteil ist, wo es aus Temperaturgründen auf große leitende Querschnitte ankommt. Darüber hinaus wird bei größeren Leitungsquerschnitten auch ein geringerer Leitungswiderstand erzielt, so dass auch sehr hohe Ströme mit wenig Verlust übertragen werden können. Infolgedessen kann auf einer einzigen Leiterplatte neben der Schaltungselektronik auch die Leistungselektronik angeordnet werden.

Ferner basiert die Erfindung auf dem Gedanken, das Leistungsvolumen einer Leiterplatte mit einem Planartransformator zu erhöhen.

Die erfindungsgemäße Leiterplatte und ein Verfahren zur ihrer Herstellung werden nachstehend mit Bezug auf die Figuren im Detail beschrieben.

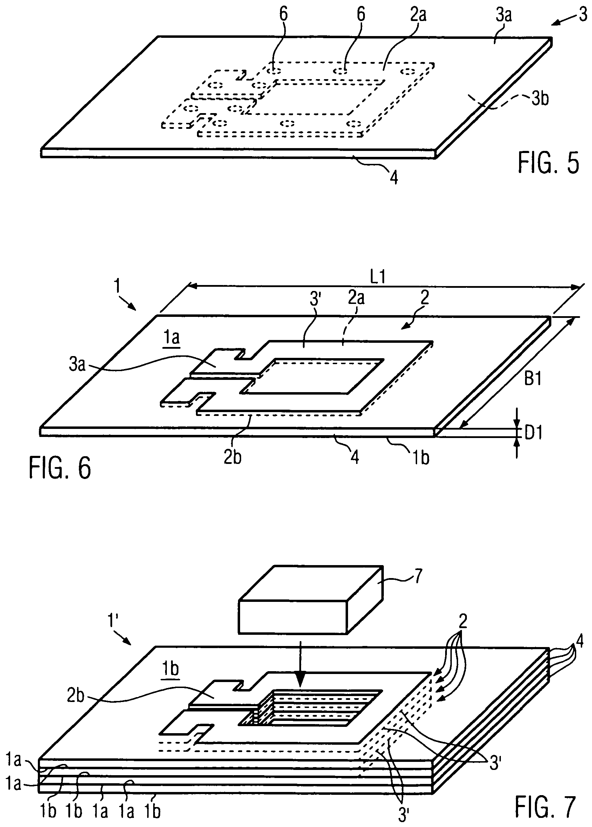

Die Leiterplatte 1 nach dem ersten Ausführungsbeispiel der Erfindung gemäß Fig. 6 umfasst ein sich in der Leiterplatte 1 erstreckendes, plattenförmiges und ebenes Formteil 2 aus Kupfer. Das Formteil 2 ist in einem Substrat aus Isolierstoffmasse 4 derart eingebettet, dass sich eine Oberseite 2a des Formteils 2 in einer Ebene mit der Oberseite 1a des Substrats befindet und bündig mit den angrenzenden und umgebenden Oberflächen des Substrats abschließt. Eine Unterseite 2b und die äußeren sowie inneren und Randseiten 2c, 2d des Formteils 2 sind vollständig mit der Isolierstoffmasse 4 bedeckt. Optional befindet sich die Unterseite 2b des Formteils 2 in einer Ebene mit der Unterseite 2a des Substrats und schließt bündig mit den angrenzenden und umgebenden Oberflächen des Substrats ab, so dass sich das Formteil 2 über die gesamte Dicke des Substrats erstreckt. Als äußere Randseiten 2c werden die nach außen gerichteten Randseiten des Formteils 2 bezeichnet, welche die Länge L2 und Breite B2 des Formteils 2 definieren. Als innere Randseiten 2d werden entsprechend die nach innen gerichteten Randseiten des Formteils 2 bezeichnet, welche im vorliegenden Fall eine im Wesentlichen rechteckförmige Aussparung 8 definieren, die sich von der äußeren Randseite 2c in das Formteil 2 hinein erstreckt. Eine Länge L2 des Formteils 2 beträgt beispielsweise ca. 87 mm. Eine Breite B2 des Formteils 2 beträgt beispielsweise ca. 38 mm und ist damit fast hundertmal so groß wie die Dicke D2 des Formteils 2. Das Formteil 2 ist aus einem plattenförmigen Werkstück 5 mit einer Dicke von bspw. 400 µm herausgetrennt, vorzugsweise durch Stanzen, Erodieren oder Scheiden, bevorzugt durch Wasserstrahlschneiden. Insgesamt ist das Formteil im Wesentlichen Ω-förmig bzw. in Form des griechischen Buchstabens Omega ausgebildet. Die Querschnittsform des Formteils 2 variiert über die Breite B2 und über die Länge L2 des Formteils 2, während die Dicke D2 des Formteils 2 über dessen gesamte Fläche konstant ist.

Die Leiterplatte 1 umfasst an ihrer Oberseite eine Anschlussstelle 3' für elektronische Bauelemente, die aus einer an den Oberseiten 2a des Formteils 2 und des Substrats 4 angebrachten, 35 µm starken Kupferfolie 3 durch Ätzung herausgearbeitet ist, so dass der Umriss der Anschlussstelle 3' bei einer Sicht auf die Oberseite 1a der Leiterplatte dem Umriss des Formteils 2 entspricht. Die Anschlussstelle 3' kontaktiert das Formteil 2 an mehreren Kontaktstellen 6, wobei diese Kontaktstellen 6 näherungsweise in regelmäßigen Abständen voneinander beabstandet sind und insbesondere an der Eckpunkten des Formteils 2 vorgesehen sind. Die Kontaktierung an den Kontaktstellen 6 ist beispielsweise eine Kontaktierung durch Schweißung, Bonden, Löten oder Leitkleben. Das Formteil 2 ist an einer Unterseite 3b der Anschlussstelle 3' angeordnet. Ein elektronisches Bauelement ist an einer Oberseite 3a der Anschlussstelle 3' anordenbar, so dass Ströme und Wärme großflächig über die Anschlussstelle 3' zwischen dem elektronischen Bauelement und dem Formteil 2 übertragbar sind.

Optional umfasst die Leiterplatte 1 geätzte Leiterbahnen z.B. aus Kupfer auf der Oberseite des Substrats, welche eine elektrische Schaltung ausbilden. Zusätzlich kann auf der Leiterplatte 1 eine Steuerelektronik und/oder eine Leistungselektronik mit elektronischen Bauelementen verwirklicht sein, deren beispielsweise geätzte Anschlussstellen durch geätzte Leiterbahnen und/oder elektrisch leitfähige Leitungsdrähte miteinander in Verbindung stehen. Wenigstens einer der Leitungsdrähte kann sich auf und/oder in der Leiterplatte 1 (zwischen Anschlussstellen) erstrecken und/oder einen rechteckförmigen oder quadratischen Querschnitt aufweisen. Vorzugsweise ist ein solcher Leiterdraht als Flachdraht aus Kupfer ausgebildet und hat die Abmessungen 0,8 ^{∗} 0,3 mm. Von dem Leitungsdraht mit rechteckförmigem Querschnitt weist beispielsweise die Seite mit der größeren Ausdehnung zur Oberseite 1a der Leiterplatte 1 hin. Der Leitungsdraht kann auch einen hohlen Querschnitt aufweisen, so dass in dem hohlen Querschnitt des Leiterdrahtes eine Kühlflüssigkeit zirkulieren kann. Die Leiterbahnen aus Kupfer, die Leitungsdrähte und die elektronischen Bauelemente sind der Einfachheit halber nicht dargestellt.

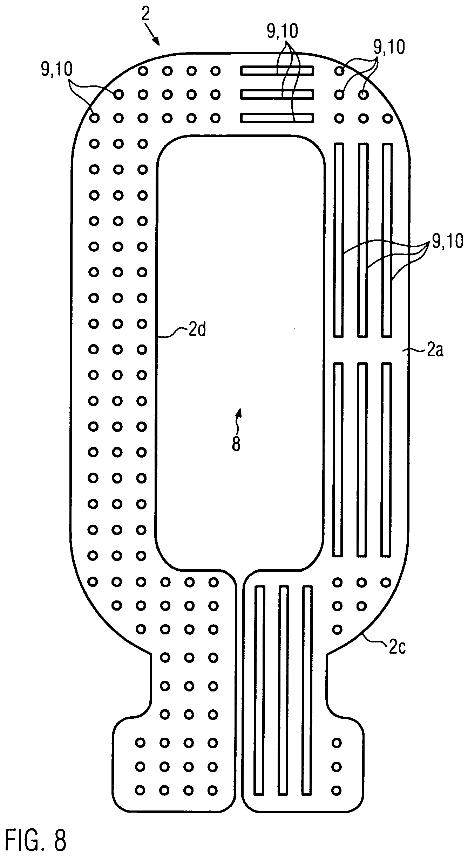

Das Formteil 2 ist in diversen Varianten ausführbar. Eine kleine Auswahl dieser Varianten wird nachstehend mit Bezug auf die Fig. 8 bis 10 diskutiert.

Das Formteil 2 gemäß Fig. 8 umfasst beispielsweise Öffnungen 9 und/oder Durchbrüche 10, die sich von der Oberseite 2a des Formteils 2 in das Formteil 2 erstrecken. Während die Durchbrüche 10 von der Oberseite bis zur Unterseite des Formteils 2 durchgehen, erstrecken sich die Öffnungen 9 nur abschnittsweise in das Formteil 2 und sind durch einen Boden begrenzt. Im Gegensatz zu den Durchbrüchen 10 sind die Öffnungen 9 nicht durchgehend. In der Ansicht der Fig. 8 sind die Öffnungen 9 und Durchbrüche 10 nicht unterscheidbar und daher jeweils mit beiden Bezugszeichen versehen. Die Öffnungen 9 und/oder Durchbrüche 10 weisen im Bereich ihrer Mündungen beispielsweise einen kreisförmigen oder rechteckigen Umriss auf. Die rechteckigen Öffnungen 9 und/oder Durchbrüche 10 verlaufen entlang von geraden Linien parallel zu den Randseiten 2c, 2d des Formteils 2. Die rechteckigen Öffnungen 9 sind dabei im Wesentlichen nutförmig ausgebildet, während die rechteckigen Durchbrüche im Wesentlichen schlitzförmig ausgebildet sind. Die Öffnungen 9 und/oder Durchbrüche 10 sind im eingebetteten Zustand vorzugsweise mit der Isolierstoffmasse 4 des Substrats der Leiterplatte 1 befüllt, so dass die Isolierstoffmasse 4 das Formteil 2 mehrfach durchdringt und für eine besonders gute, formschlüssige Verbindung mit dem Formteil 2 sorgt.

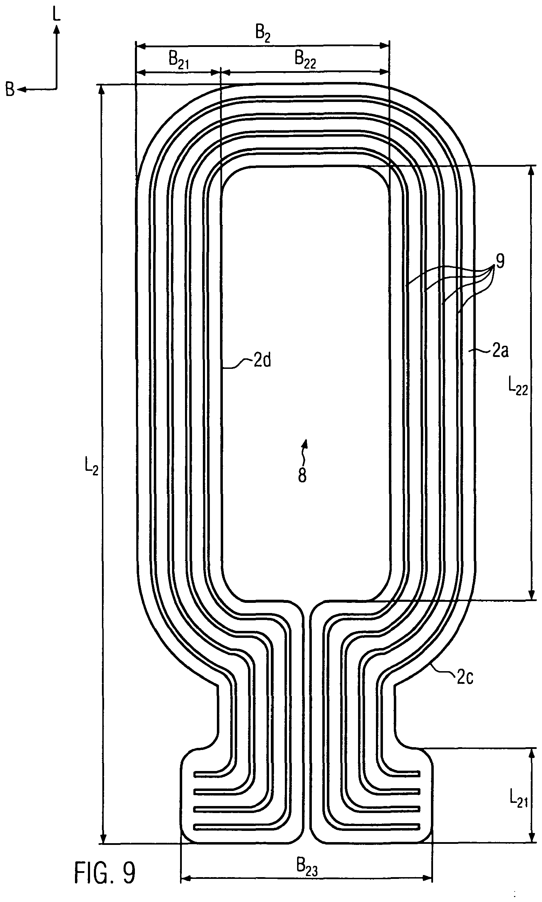

Das Formteil 2 gemäß Fig. 9 umfasst in Abwandlung der Fig. 8 Öffnungen 9, die sich kontinuierlich entlang von schleifenförmigen und mehrfach gekrümmten Linien parallel zu den Randseiten 2c, 2d des Formteils 2 im Wesentlichen um dessen gesamten Umfang erstrecken. Die bevorzugten Abmessungen des Formteils sind (+/- 10 % Abweichung möglich): B3 = 38 mm; B21 = 9,5 mm; B22 = 19 mm; B23 = 28 mm; L2 = 86,72 mm; L21 = 10,6 mm; L22 = 49,9 mm.

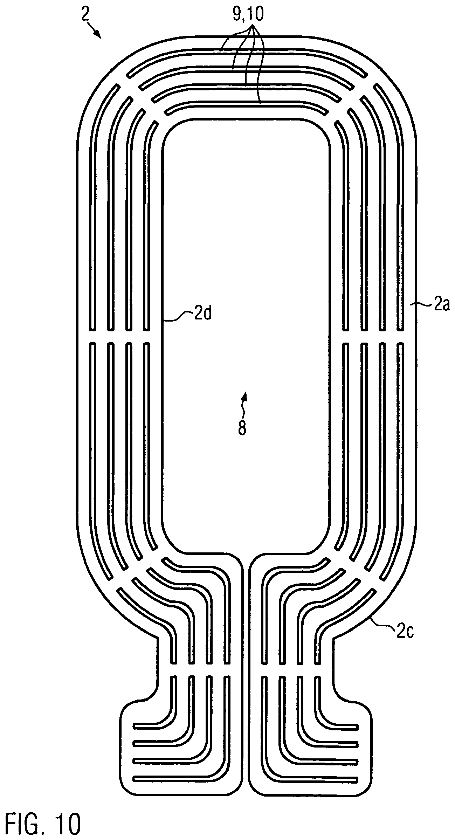

Das Formteil 2 gemäß Fig. 10 umfasst in Abwandlung der Fig. 9 Durchbrüche 10, die sich diskontinuierlich entlang von schleifenförmigen und mehrfach gekrümmten Linien parallel zu den Randseiten 2c, 2d des Formteils 2 im Wesentlichen um dessen gesamten Umfang erstrecken. Durch die rasterförmigen Querverbindungen des Formteils 2 zwischen den Durchbrüchen 10 bleibt eine gewisse Steifigkeit des Formteils 2 auch trotz der zahlreichen Durchbrüche 10 erhalten.

Die Leiterplatte 1 nach dem zweiten Ausführungsbeispiel der Erfindung gemäß Fig. 7 umfasst mehrere Schichten von Leiterplatten 1 nach dem ersten Ausführungsbeispiel der Erfindung gemäß Fig. 6 mit jeweils einem Formteil 2, wobei die Formteile 2 in den mehreren Schichten identisch ausgebildet sind und in einer Richtung senkrecht zur Oberseite der Leiterplatte 1 genau übereinander liegen. Bei der in Fig. 7 gezeigten Ausführung sind zwei benachbarte Schichten vorzugsweise paarweise spiegelverkehrt übereinander liegend derart angeordnet, dass deren Anschlussstellen 3' unmittelbar aufeinander liegen und einander kontaktieren. Dabei weisen die Oberseiten 1a, 1a oder die Unterseiten 1b, 1b von zwei benachbarten Schichten zueinander. Dazu ist es hilfreich, dass die Formteile 2 spiegelsymmetrisch zu ihrer Längsachse ausgebildet sind. Eine Öffnung erstreckt sich ausgehend von der Oberseite der Leiterplatte 1 bzw. von der Unterseite 1b der obersten Schicht durch mehrere Schichten in die Leiterplatte 1, um einen gesinterten Mu-Metall-Magnetkörper 7 in dieser Öffnung aufzunehmen. Dabei umgibt jedes Formteil 2 den Magnetkörper 7 im Wesentlichen vollumfänglich, um die Wicklungen eines Planartransformators um einen Transformatorkern in Gestalt des Magnetkörpers 7 zu bilden. Dadurch kann ein Planartransformator mit besonders großen Wicklungsquerschnitten und besonders hoher Leistungskapazität geschaffen werden.

Ein erfindungsgemäßes Verfahren zur Herstellung einer erfindungsgemäßen Leiterplatte 1 umfasst die folgenden Schritte:
- Schritt a: Bereitstellen des plattenförmigen Formteils 2 durch Heraustrennen des Formteils 2 aus einem plattenförmigen Werkstück 5, vorzugsweise durch Stanzen, Erodieren oder Scheiden, bevorzugt Wasserstrahlschneiden.
- Schritt b: Kontaktieren des Formteils 2 mit der elektrisch leitenden Folie 3 an der wenigstens einen Kontaktstelle 6 durch Schweißung, Bonden, Löten oder Leitkleben, wobei vorzugsweise in wenigstens einem Bereich zwischen der Folie 3 und dem Formteil, bevorzugt in einem Bereich zwischen zwei Kontaktstellen 6 und/oder in einem Bereich, der wenigstens eine Kontaktstelle 6 umgibt, vorab eine Isolierstoffmasse 4 angeordnet wird, wobei die Isolierstoffmasse 4 besonders bevorzugt auf das Formteil 2 aufgebracht wird.
- Schritt c: Aufbringen einer Deckschicht 4 auf die mit dem Formteil 2 verbundene Seite 3b der Folie 3 durch Verpressen der Seite 3b der Folie 3 mit einem Prepreg aus Isolierstoffmasse.
- Schritt d: Herausarbeiten wenigstens einer Anschlussstelle 3' aus der Folie durch Ätzung.

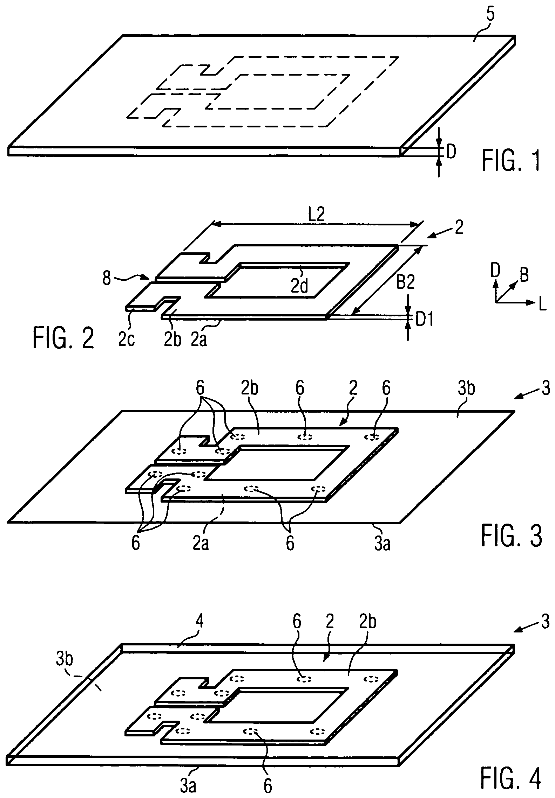

Fig. 1 zeigt eine perspektivische Ansicht einer 400 µm dicken Kupferplatte 5, auf der der Umriss eines Formteils skizziert ist, um das Formteil entlang des Umrisses gemäß Schritt a aus dem Werkstück herauszutrennen.

Fig. 2 zeigt eine perspektivische Ansicht des gemäß Schritt a aus der Kupferplatte herausgetrennten Formteils 2. Vorzugsweise wird die zur Kontaktierung der Folie 3 bzw. Anschlussstelle 3' vorgesehene Seite des Formteils 2 bereits vor dem Aufbringen auf die Folie 3 mit einer Isolierstoffmasse 4 bestrichen, wobei die zur Kontaktierung der Folie 3 bzw. Anschlussstelle 3' vorgesehenen Stellen, an denen sie die späteren Kontaktstellen 6 befinden, ausgespart werden. Dadurch kann das Formteil 2 gegenüber der Folie 3 optimal positioniert werden. Ferner können die Kontaktstellen 6 durch Schweißung, Bonden, Löten oder Leitkleben, insbesondere durch Ultraschallschweißen, besonders genau definiert und daher besonders leicht erzeugt werden, weil der Kontakt zwischen dem Formteil 2 und der Folie 3 nur in den von Isolierstoffmasse freigehaltenen bzw. ausgesparten Bereichen möglich ist, aber nicht in den Bereichen, in denen die Isolierstoffmasse 4 zwischen dem Formteil 2 und der Folie 3 angeordnet ist.

Fig. 3 zeigt eine perspektivische Ansicht eines weiteren Zwischenprodukts in dem Verfahren zur Herstellung der erfindungsgemäßen Leiterplatte nach Schritt b, wonach die Oberseite 2a des Formteils 2 die Unterseite 3b einer elektrisch leitenden, 35 µm dicken Kupferfolie 3 an Kontaktstellen 6 kontaktiert. Das Bezugszeichen 3a bezeichnet eine Oberseite der Kupferfolie 3.

Fig. 4 zeigt eine perspektivische Ansicht eines weiteren Zwischenprodukts mit Blickrichtung auf dessen Unterseite, wobei die das Formteil 2 kontaktierende Unterseite 3b der Folie 3 im Einklang mit Schritt c mit einer elektrisch isolierenden Deckschicht versehen wird, um das Formteil 2 einzubetten und elektrisch zu isolieren.

Fig. 5 zeigt eine andere perspektivische Ansicht des Zwischenprodukts gemäß Fig. 4 mit Blickrichtung auf die Oberseite des Zwischenprodukts.

Die Ätzung der Kupferfolie 3 erfolgt erfindungsgemäß erst nach dem Einbetten des Formteils 2 in die Isolierstoffmasse 4, die das Substrat der Leiterplatte 1 bildet, um die Bereiche der Kontaktstellen 6 zur Bildung einer Anschlussstelle 3' aus der Kupferfolie 3 herauszuarbeiten. Da die Position des Formteils 2 und die Positionen der Kontaktstellen 6 bereits vorab bekannt sind, können die Verbindungen des Formteils 2 mit der eigentlich noch nicht vorhandenen Anschlussstelle 3' bereits vor dem Einbetten des Formteils 2 in die Isolierstoffmasse 4 und/oder vor dem Herausarbeiten der Anschlussstelle 3' aus der Kupferfolie 3 gefertigt werden.

Die Erfindung ist nicht auf die beschriebenen Ausführungsbeispiele beschränkt. Weitere vorteilhafte Ausführungen ergeben sich aus den Patentansprüchen.

## Patentansprüche

1. Leiterplatte (1) mit wenigstens einer Anschlussstelle (3') und mit wenigstens einem sich in der Leiterplatte (1) erstreckenden, plattenförmigen Formteil (2) aus einem elektrisch leitenden Werkstoff, wobei
die Leiterplatte (1) ein Substrat aus Isolierstoffmasse (4) aufweist und das Formteil (2) mit der Isolierstoffmasse (4) bedeckt ist,
die Anschlussstelle (3') das Formteil (2) an wenigstens einer Kontaktstelle (6) kontaktiert, das Formteil (2) wenigstens eine Öffnung (9), die sich von der Oberseite (2a), der Unterseite (2b) oder einer Randseite (2c, 2d) des Formteils (2) abschnittsweise in das Formteil (2) erstreckt, und/oder wenigstens einen Durchbruch (10), der sich quer zur Oberseite (2a), zur Unterseite (2b) oder einer Randseite (2c, 2d) des Formteils (2) durch das Formteil (2) erstreckt, umfasst,
**dadurch gekennzeichnet, dass**
die Anschlussstelle (3') aus einer elektrisch leitenden Folie (3) herausgearbeitet ist.

2. Leiterplatte (1) nach Anspruch 1, **dadurch gekennzeichnet, dass** eine Oberseite (2a) und/oder eine Unterseite (2b) und/oder wenigstens eine der Randseiten (2c, 2d) des Formteils (2), vorzugsweise alle Randseiten des Formteils (2), zumindest abschnittsweise, vorzugsweise vollständig, mit der Isolierstoffmasse (4) bedeckt ist/sind.

3. Leiterplatte (1) nach wenigstens einem der vorangehenden Ansprüche, **dadurch gekennzeichnet, dass** das Formteil (2) einen Magnetkörper (7) zumindest abschnittsweise, vorzugsweise vollumfänglich, umgibt, wobei das Formteil (2) und/oder der Magnetkörper (7) bevorzugt Bestandteile eines Planartransformators bilden.

4. Leiterplatte (1) nach wenigstens einem der vorangehenden Ansprüche, **dadurch gekennzeichnet, dass** die Leiterplatte (1) mehrere Schichten mit jeweils wenigstens einem Formteil (2) aufweist, wobei die Formteile (2) in den mehreren Schichten vorzugsweise identisch ausgebildet sind und bevorzugt in einer Richtung senkrecht zur Oberseite der Leiterplatte (1) genau oder spiegelverkehrt übereinander liegen, wobei sich vorzugsweise identisch ausgebildet sind und bevorzugt in einer Richtung senkrecht zur Oberseite der Leiterplatte (1) genau oder spiegelverkehrt übereinander liegen, wobei sich vorzugsweise eine Öffnung ausgehend von der Oberseite und/oder der Unterseite der Leiterplatte (1) durch mehrere Schichten in die Leiterplatte (1) erstreckt, wobei der Magnetkörper (7) besonders bevorzugt in dieser Öffnung angeordnet ist.

5. Leiterplatte (1) nach wenigstens einem der vorangehenden Ansprüche, **dadurch gekennzeichnet, dass** das wenigstens eine Formteil (2) wenigstens eine der folgenden Anforderungen erfüllt:
a. Das Formteil (2) erstreckt sich im Wesentlichen in einer Ebene.
b. Das Formteil (2) besteht aus Metall, vorzugsweise aus Kupfer.
c. Das Formteil (2) ist zumindest abschnittsweise, vorzugsweise vollständig, in der Leiterplatte (1) eingebettet.
d. Die Oberseiten (1a, 2a) der Leiterplatte (1) und des Formteils (2) sind im Wesentlichen parallel zueinander ausgerichtet.
e. Das Formteil (2) ist aus einem plattenförmigen Werkstück (5) herausgetrennt, vorzugsweise durch Stanzen, Erodieren oder Scheiden, bevorzugt durch Wasserstrahlschneiden.
f. Das Formteil (2) weist eine Dicke im Bereich von 10 bis 2000 µm, vorzugsweise im Bereich von 100 bis 1000 µm, bevorzugt im Bereich von 200 bis 500 µm auf.
g. Eine Länge (L2) und/oder Breite (B2) des Formteils (2) ist wenigstens fünfmal, vorzugsweise wenigstens zehnmal, bevorzugt wenigstens zwanzigmal, bevorzugt wenigstens fünfzigmal oder bevorzugt wenigstens hundertmal so groß wie die Dicke (D2) des Formteils (2) und/oder die Dicke (D1) der Leiterplatte (1).
h. Das Formteil (2) umfasst einen im Wesentlichen rechteckförmigen Querschnitt.
i. Die Querschnittsform des Formteils (2) variiert über die Breite (B2) und/oder über die Länge (L2) des Formteils (2).
j. Die Dicke (D2) des Formteils (2) ist über dessen gesamte Fläche konstant.
k. Das Formteil (2) umfasst eine Krümmung in einer, zwei, drei oder mehr Krümmungsebenen.
l. Das Formteil (2) steht zumindest abschnittsweise aus dem Substrat der Leiterplatte hervor.
m. Das Formteil (2) ist nicht im Strangpressverfahren herstellbar oder hergestellt.
n. Das Formteil (2) umfasst wenigstens eine Ausnehmung (8), die ausgehend von einer Randseite (2c) des Formteils (2) in das Formteil (2) eingearbeitet ist.
o. Die Öffnung (9) des Formteils (2) umfasst vorzugsweise zumindest im Bereich ihrer Mündung einen kreisförmigen, ovalen, polygonalen, vorzugsweise dreieckigen, viereckigen, fünfeckigen, bevorzugt rechteckigen oder quadratischen Umriss, wobei die Öffnung (9) bevorzugt im Wesentlichen nutförmig ausgebildet ist und sich kontinuierlich oder diskontinuierlich entlang einer geraden oder gekrümmten Linie erstreckt, wobei diese Linie besonders bevorzugt zumindest abschnittsweise parallel zu einer Randseite (2c, 2d) des Formteils (2) verläuft, wobei die Öffnung (9) besonders bevorzugt zumindest abschnittsweise mit Isolierstoffmasse (4) befüllt ist.
p. Der Durchbruch (10) des Formteils (2) erstreckt sich senkrecht zur Oberseite (2a), zur Unterseite (2b) oder einer Randseite (2c, 2d) des Formteils (2) durch das Formteil (2), wobei der Durchbruch (10) vorzugsweise einen kreisförmigen, ovalen, polygonalen, vorzugsweise dreieckigen, viereckigen, fünfeckigen, rechteckigen oder quadratischen Umriss umfasst, wobei der Durchbruch (10) bevorzugt im Wesentlichen schlitzförmig ausgebildet ist und sich kontinuierlich oder diskontinuierlich entlang einer geraden oder gekrümmten Linie erstreckt, wobei diese Linie besonders bevorzugt zumindest abschnittsweise parallel zu einer Randseite (2c, 2d) des Formteils (2) verläuft, wobei der Durchbruch (10) besonders bevorzugt zumindest abschnittsweise mit Isolierstoffmasse (4) befüllt ist.
q. Das Formteil (2) ist im Wesentlichen L-förmig, T-förmig, H-förmig, S-förmig, O-förmig, E-förmig, F-förmig, X-förmig, Y-förmig, Z-förmig, C-förmig, U-förmig oder Ω-förmig ausgebildet.
r. Mehrere Formteile (2) sind in derselben Ebene oder in verschiedenen Ebenen, vorzugsweise in zueinander parallelen Ebenen innerhalb der Leiterplatte (1) angeordnet.

6. Leiterplatte nach wenigstens einem der vorangehenden Ansprüche, **dadurch gekennzeichnet, dass** die wenigstens eine Anschlussstelle (3') wenigstens eine der folgenden Anforderungen erfüllt:
a. Die Anschlussstelle (3') ist an der Oberseite (1a) der Leiterplatte (1) angeordnet.
b. Die Anschlussstelle (3') kontaktiert wenigstens einen Leitungsdraht und/oder wenigstens ein elektronisches Bauelement an jeweils wenigstens einer Kontaktstelle (6), wobei vorzugsweise mehrere Kontaktstellen (6) in bevorzugt regelmäßigen Abständen voneinander beabstandet sind.
c. Das Formteil (2) und/oder wenigstens ein Leitungsdraht ist an einer Unterseite (3b) der Anschlussstelle (3') angeordnet.
d. Ein elektronisches Bauelement und/oder wenigstens ein Leitungsdraht ist an einer Oberseite (3a) der Anschlussstelle (3') angeordnet oder anordenbar.
e. Die Kontaktierung an der wenigstens einen Kontaktstelle (6) ist eine Kontaktierung durch Schweißung, Bonden, Löten oder Leitkleben.
f. Die Anschlussstelle (3') besteht aus Metall, vorzugsweise aus Kupfer.
g. Die Anschlussstelle (3') ist durch Ätzung aus der Folie (3) herausgearbeitet.
h. Die Anschlussstelle (3') umfasst eine Dicke im Bereich von 1 bis 200 µm, vorzugsweise im Bereich von 10 bis 100 µm, bevorzugt im Bereich von 20 bis 50 µm.
i. Der Umriss der Anschlussstelle (3') entspricht zumindest abschnittsweise oder vollständig dem Umriss des Formteils (2) bei einer Sicht auf die Oberseite (1a) der Leiterplatte.
j. In wenigstens einem Bereich zwischen der Anschlussstelle (3') und dem Formteil (2), vorzugsweise in einem Bereich zwischen zwei Kontaktstellen (6) und/oder in einem Bereich, der wenigstens eine Kontaktstelle (6) umgibt, ist eine Isolierstoffmasse (4) angeordnet.
k. Mehrere Anschlussstellen (3') stehen über das Formteil (2) und/oder über wenigstens einen Leitungsdraht und/oder über wenigstens eine geätzte Leiterbahn in Verbindung.

7. Leiterplatte (1) nach wenigstens einem der vorangehenden Ansprüche, **dadurch gekennzeichnet, dass** auf der Leiterplatte (1) Schaltungselektronik und/oder Leistungselektronik angeordnet ist.

8. Verfahren zur Herstellung einer Leiterplatte (1), vorzugsweise einer Leiterplatte (1) nach wenigstens einem der vorangehenden Ansprüche, umfassend die folgenden Schritte:
a. Bereitstellen eines plattenförmigen Formteils (2) aus einem elektrisch leitenden Werkstoff;
b. Kontaktieren des Formteils (2) mit einer elektrisch leitenden Folie (3) an wenigstens einer Kontaktstelle (6);
c. Aufbringen einer Deckschicht (4) auf die das Formteil (2) kontaktierende Seite (3b) der Folie (3); und
d. Herausarbeiten wenigstens einer Anschlussstelle (3') aus der Folie.

9. Verfahren zur Herstellung einer Leiterplatte (1) nach wenigstens einem der vorangehenden Ansprüche, **dadurch gekennzeichnet, dass** das Verfahren wenigstens eine der folgenden Anforderungen erfüllt:
a. Das Bereitstellen des plattenförmigen Formteils (2) erfolgt durch Trennen des Formteils (2) von einem plattenförmigen Werkstück (5), vorzugsweise durch Stanzen, Erodieren oder Scheiden, bevorzugt Wasserstrahlschneiden.
b. Das Kontaktieren des Formteils (2) mit der elektrisch leitenden Folie (3) an der wenigstens einen Kontaktstelle (6) erfolgt durch Schweißung, Bonden, Löten oder Leitkleben, wobei vorzugsweise in wenigstens einem Bereich zwischen der Folie (3) und dem Formteil (2), bevorzugt in einem Bereich zwischen zwei Kontaktstellen (6) und/oder in einem Bereich, der wenigstens eine Kontaktstelle (6) umgibt, vorab eine Isolierstoffmasse (4) angeordnet wird, wobei die Isolierstoffmasse (4) besonders bevorzugt auf das Formteil (2) aufgebracht wird.
c. Das Aufbringen einer Deckschicht (4) auf die das Formteil (2) kontaktierende Seite (3b) der Folie (3) erfolgt durch Verpressen der Seite (3b) der Folie (3) mit einem Prepreg aus Isolierstoffmasse.
d. Das Herausarbeiten wenigstens einer Anschlussstelle (3') aus der Folie erfolgt durch Ätzung.

## Claims

1. Printed circuit board (1) comprising at least one connection point (3') and comprising at least one shaped part (2) made of an electrically conductive material extending in the printed circuit board (1), wherein
the printed circuit board (1) comprises a substrate made of insulation material (4), and the shaped part (2) is covered by the insulation material (4),
the connection point (3') contacts the shaped part (2) on at least one contact point (6), the shaped part (2) has at least one hole (9), which extends from the upper side (2a), the lower side (2b) or a marginal side (2c, 2d) of the shaped part (2) partially into the shaped part (2), and/or at least one through-hole (10), which extends transversely, to the upper side (2a), to the lower side (2b) or to a marginal side (2c, 2d) of the shaped part (2) through the shaped part (2),
**characterized in that**
the connection point (3') is carved out from a foil (3).

2. Printed circuit board (1) according to claim 1, **characterized in that** an upper side (2a) and/or a lower side (2b) and/or at least one of the marginal sides (2c, 2d) of the shaped part (2), preferably all marginal sides of the shaped part (2) is/are at least partially, preferably completely, covered by the insulation material (4).

3. Printed circuit board (1) according to at least one of the preceding claims, **characterized in that** the shaped part (2) encompasses a magnetic body (7) at least partially, preferably completely, wherein the shaped part (2) and/or the magnetic body (7) preferably form parts of a planar transformer.

4. Printed circuit board according to at least one of the preceding claims, **characterized in that** the printed circuit board (1) comprises a plurality of layers with at least one shaped part (2), wherein the shaped parts (2) in the plurality of layers are preferably formed identically and are preferably stacked on top of each other in accurate or mirror-inverted manner in a direction perpendicular to the upper side of the printed circuit board (1), wherein preferably one hole starting out from the upper side and/or lower side of the printed circuit board (1) extends through a plurality of layers into the printed circuit board (1), wherein the magnetic body (7) is especially preferably arranged in this hole.

5. Printed circuit board (1) according to at least one of the preceding claims, **characterized in that** the at least one shaped part (2) fulfills at least one of the following requirements:
a. The shaped part (2) extends substantially on one plane.
b. The shaped part (2) is made of metal, preferably of copper.
c. The shaped part (2) is at least partially, preferably completely, embedded in the printed circuit board (1).
d. The upper sides (1a, 2a) of the printed circuit board (1) and of the shaped part (2) are aligned substantially in parallel to each other.
e. The shaped part (2) is detached from a plate-shaped workpiece (5), preferably by punching, eroding or cutting, preferably by water jet cutting.
f. The shaped part (2) has a thickness in the range of 10 to 2000 µm, preferably in the range of 100 to 1000 µm, preferably in the range of 200 to 500 µm.
g. A length (L2) and/or width (B2) of the shaped part (2) is at least five times, preferably at least ten times, preferably at least twenty times, preferably at least fifty times or preferably at least hundred times as large as the thickness (D2) of the shaped part (2) and/or the thickness (D1) of the printed circuit board (1).
h. The shaped part (2) has a substantially rectangular cross-section.
i. The cross-sectional shape of the shaped part (2) varies across the width (B2) and/or across the length (L2) of the shaped part (2).
j. The thickness (D2) of the shaped part (2) is constant across its entire surface.
k. The shaped part (2) has a curvature in one, two, three or more curvature planes.
l. The shaped part (2) projects at least partially from the substrate of the printed circuit board.
m. The shaped part (2) cannot be manufactured or is not manufactured by an extrusion process.
n. The shaped part (2) has at least one recess (8), which starting out from a marginal side (2c) of the shaped part (2) is worked into the shaped part (2).
o. The hole (9) has preferably at least in the area of its opening a circular, oval, polygonal, preferably triangular, quadrangular, pentagonal, preferably rectangular or square contour, wherein the hole (9) is preferably substantially groove-shaped and extends continuously or discontinuously along a straight or curved line, wherein this line extends especially preferably at least partially in parallel to a marginal side (2c, 2d) of the shaped part (2), wherein the hole (9) is especially preferably at least partially filled with insulation material (4).
p. The through-hole (10) preferably has a circular, oval, polygonal, preferably triangular, quadrangular, pentagonal, rectangular or square contour, wherein the through-hole (10) is preferably substantially slot-shaped and extends continuously or discontinuously along a straight or curved line, wherein this line extends especially preferably at least partially in parallel to a marginal side (2c, 2d) of the shaped part (2), wherein the through-hole (10) is especially preferably at least filled partially with insulation material (4).
q. The shaped part (2) is substantially L-shaped, T-shaped, H-shaped, S-shaped, O-shaped, E-shaped, F-shaped, Y-shaped, Z-shaped, C-shaped, U-shaped or Ω-shaped.
r. A plurality of shaped parts (2) are arranged in the same plane or in different planes, preferably in planes parallel to each other within the printed circuit board (1).

6. Printed circuit board according to at least one of the preceding claims, **characterized in that** the at least one connection point (3') fulfills at least one of the following requirements:
a. The connection point (3') is arranged on the upper side (1a) of the printed circuit board (1).
b. The connection point (3') contacts at least a line wire and/or a least an electronic component on at least one contact point (6), wherein preferably a plurality of contact points (6) in preferably regular spacings are spaced apart from each other.
c. The shaped part (2) and/or at least one line wire is arranged on a lower side (3b) of the connection point (3').
d. An electronic component and/or at least one line wire is arranged or can be arranged at an upper side (3a) of the connection point (3').
e. The contacting at the at least one contact point (6) is a contacting by welding, bonding, soldering or conductive adhesion.
f. The connection point (3') is made of metal, preferably of copper.
g. The connection point (3') is carved out from the foil (3) by etching.
h. The connection point (3') has a thickness in the range of 1 to 200 µm, preferably in the range of 10 to 100 µm, preferably in the range of 20 to 50 µm.
i. The contour of the connection point (3') corresponds at least partially or completely to the contour of the shaped part (2) at a view onto the upper side (1a) of the printed circuit board.
j. An insulation material (4) is arranged in at least one portion between the connection point (3') and the shaped part (2), preferably in a portion between two contact points (6) and/or in a portion that encompasses at least one contact point (6).
k. A plurality of connection points (3') communicate via the shaped part (2) and/or via at least one line wire and/or via at least one etched strip conductor.

7. Printed circuit board (1) according to at least one of the preceding claims, **characterized in that** circuit electronic devices and/or power electronic devices are arranged on the printed circuit board (1).

8. A method of producing a printed circuit board (1), preferably a printed circuit board (1) according to at least one of the preceding claims, comprising the following steps:
a. Providing a shaped part (2) made of an electrically conductive material;
b. Contacting the shaped part (2) by an electrically conductive foil (3) on at least one contact point (6);
c. Applying a cover layer (4) onto the side (3b) of the foil (3) contacting the shaped part; and
d. Carving out at least one connection point (3') from the foil.

9. A method of producing a printed circuit board (1) according to at least one of the preceding claims, **characterized in that** the method fulfills at least one of the following requirements:
a. The provision the shaped part (2) is carried out by separating the shaped part (2) from a plate-shaped workpiece (5), preferably by punching, eroding or cutting, preferably by water jet cutting.
b. The contacting of the shaped part (2) by the electrically conductive foil (3) at the at least one contact point (3) is carried out by welding, bonding, soldering or conductive adhesion, wherein preferably in a portion between the foil (3) and the shaped part (2), preferably in a portion between two contact portions (6) and/or in a portion, which encompasses at least one contact point (6), insulation material (4) is previously arranged, wherein the insulation material (4) is especially preferably attached onto the shaped part (2).
c. The attachment of a cover layer (4) onto the side (3b) of the foil (3) contacting the shaped part (2) is carried out by pressing the side (3b) of the foil (3) to a prepreg made of insulation material.
d. The carving out of at least one connection point (3') from the foil is carried out by means of etching.

## Revendications

1. Plaque de circuit imprimé (1) comprenant au moins une zone de raccordement (3') et au moins une pièce de forme (2) en forme de plaque, en un matériau électriquement conducteur, qui s'étend à l'intérieur de la plaque de circuit imprimé (1),
la plaque de circuit imprimé (1) présentant un substrat en une masse de matériau isolant (4), et la pièce de forme (2) étant recouverte par la masse de matériau isolant (4),
la zone de raccordement (3') contacte la pièce de forme (2) au niveau d'au moins une zone de contact (6),
la pièce de forme (2) comprenant au moins une ouverture (9), qui s'étend à partir du côté supérieur (2a), du côté inférieur (2b) ou d'un côté de bordure (2c, 2d) de la pièce de forme (2), par secteurs, à l'intérieur de la pièce de forme (2), et/ou au moins un passage (10), qui s'étend transversalement au côté supérieur (2a), au côté inférieur (2b) ou à un côté de bordure (2c, 2d) de la pièce de forme (2), à travers la pièce de forme (2), **caractérisée**
**en ce que** la zone de raccordement (3') est produite par usinage par enlèvement de matière dans une feuille (3) électriquement conductrice.

2. Plaque de circuit imprimé (1) selon la revendication 1, **caractérisée en ce qu'**un côté supérieur (2a) et/ou un côté inférieur (2b) et/ou au moins un des côtés de bordure (2c, 2d) de la pièce de forme (2), de préférence tous les côtés de bordure de la pièce de forme (2) est/sont recouvert(s), au moins en partie et de préférence en totalité, par la masse de matériau isolant (4).

3. Plaque de circuit imprimé (1) selon l'une au moins des revendications précédentes, **caractérisée en ce que** la pièce de forme (2) entoure un corps d'aimant (7), au moins par secteurs, de préférence en totalité, la pièce de forme (2) et/ou le corps d'aimant (7) formant de préférence des pièces constitutives d'un transformateur planaire.

4. Plaque de circuit imprimé (1) selon l'une au moins des revendications précédentes, **caractérisée en ce que** la plaque de circuit imprimé (1) comprend plusieurs couches avec chacune au moins une pièce de forme (2), **en ce que** les pièces de forme (2) dans lesdites plusieurs couches sont de préférence de configuration identique et sont placées, de préférence dans une direction perpendiculaire au côté supérieur de la plaque de circuit imprimé (1), les unes au-dessus des autres en se superposant de manière exacte ou inversée selon une image de miroir, **en ce que** de préférence une ouverture issue du côté supérieur et/ou du côté inférieur de la plaque de circuit imprimé (1), s'étend vers l'intérieur de la plaque de circuit imprimé (1), à travers plusieurs couches, et **en ce que** le corps d'aimant (7) est de manière particulièrement préférée agencé dans cette ouverture.

5. Plaque de circuit imprimé (1) selon l'une au moins des revendications précédentes, **caractérisée en ce que** ladite au moins une pièce de forme (2) satisfait à au moins une des exigences suivantes :
a. La pièce de forme (2) s'étend sensiblement dans un plan.
b. La pièce de forme (2) est réalisée en métal, de préférence en cuivre.
c. La pièce de forme (2) est noyée, au moins par secteurs, de préférence en totalité, dans la plaque de circuit imprimé (1).
d. Les côtés supérieurs (la, 2a) de la plaque de circuit imprimé (1) et de la pièce de forme (2) sont orientés sensiblement de manière à être mutuellement parallèles.
e. La pièce de forme (2) est sectionnée hors d'une pièce (5) en forme de plaque, de préférence par découpage à la matrice, érosion ou découpage, de préférence par découpage au jet d'eau.
f. La pièce de forme (2) présente une épaisseur dans une plage de 10 à 2000 µm, de préférence dans une plage de 100 à 1000 µm, de manière préférée dans une plage de 200 à 500 µm.
g. Une longueur (L2) et/ou largeur (B2) de la pièce de forme (2) est au moins cinq fois, de préférence au moins dix fois, plus particulièrement au moins vingt fois, de manière préférée au moins cinquante fois ou de préférence au moins cent fois aussi grande que l'épaisseur (D2) de la pièce de forme (2) et/ou l'épaisseur (D1) de la plaque de circuit imprimé (1).
h. La pièce de forme (2) présente une section transversale sensiblement de forme rectangulaire.
i. La forme de section transversale de la pièce de forme (2) varie sur la largeur (B2) et/ou sur la longueur (L2) de la pièce de forme (2).
j. L'épaisseur (D2) de la pièce de forme (2) est constante sur la totalité de sa surface.
k. La pièce de forme (2) présente une courbure dans un, deux, trois plans de courbure ou davantage.
l. La pièce de forme (2) fait saillie, au moins par secteurs, du substrat de la plaque de circuit imprimé.
m. La pièce de forme (2) ne peut pas être fabriquée ou n'est pas fabriquée selon un procédé d'extrusion.
n. La pièce de forme (2) comporte au moins un évidement (8), qui est usiné dans la pièce de forme (2) en partant d'un côté de bordure (2c) de la pièce de forme (2).
o. L'ouverture (9) de la pièce de forme (2) présente, de préférence au moins dans la zone de son embouchure, un tracé de pourtour de forme circulaire, ovale, polygonale, de préférence triangulaire, quadrangulaire, pentagonale, de manière préférée rectangulaire ou carrée, l'ouverture (9) étant de préférence réalisée sensiblement en forme de rainure, et s'étendant de manière continue ou discontinue le long d'une ligne rectiligne ou courbe, cette ligne s'étendant de manière particulièrement préférée, au moins par secteurs, parallèlement à un côté de bordure (2c, 2d) de la pièce de forme (2), et l'ouverture (9) étant de manière particulièrement préférée, remplie, au moins par secteurs, par la masse de matériau isolant (4).
p. Le passage (10) de la pièce de forme (2) s'étend perpendiculairement au côté supérieur (2a), au côté inférieur (2b) ou à un côté de bordure (2c, 2d) de la pièce de forme (2), à travers la pièce de forme (2), le passage (10) présentant de préférence un tracé de pourtour de forme triangulaire, quadrangulaire, pentagonale, rectangulaire ou carrée, le passage (10) étant de préférence réalisé sensiblement en forme de fente, et s'étendant de manière continue ou discontinue le long d'une ligne rectiligne ou courbe, cette ligne s'étendant de manière particulièrement préférée, au moins par secteurs, parallèlement à un côté de bordure (2c, 2d) de la pièce de forme (2), et le passage (10) étant de manière particulièrement préférée, rempli, au moins par secteurs, par la masse de matériau isolant (4).
q. La pièce de forme (2) est sensiblement réalisée en forme de L, en forme de T, en forme de H, en forme de S, en forme de 0, en forme de E, en forme de F, en forme de X, en forme de Y, en forme de Z, en forme de C, en forme de U ou en forme de Ω.
r. Plusieurs pièces de forme (2) sont agencées dans le même plan ou dans des plans différents, de préférence des plans mutuellement parallèles, à l'intérieur de la plaque de circuit imprimé (1).

6. Plaque de circuit imprimé selon l'une au moins des revendications précédentes, **caractérisée en ce que** ladite au moins une zone de raccordement (3') satisfait à au moins une des exigences suivantes :
a. La zone de raccordement (3') est agencée sur le côté supérieur (1a) de la plaque de circuit imprimé (1).
b. La zone de raccordement (3') contacte au moins un fil conducteur et/ou au moins un composant électronique respectivement au niveau d'au moins une zone de contact (6), plusieurs zones de contact (6) étant de préférence agencées de manière mutuellement espacées, de préférence selon des distances d'espacement régulières.
c. La pièce de forme (2) et/ou au moins un fil conducteur est agencé(e) sur un côté inférieur (3b) de la zone de raccordement (3').
d. Un composant électronique et/ou au moins un fil conducteur est agencé ou peut être agencé sur un côté supérieur (3a) de la zone de raccordement (3').
e. Le contact au niveau de ladite au moins une zone de contact (6) est un contact obtenu par soudage, bonding, brasage ou collage conducteur.
f. La zone de raccordement (3') est en métal, de préférence en cuivre.
g. La zone de raccordement (3') est usinée par gravure de la feuille (3).
h. La zone de raccordement (3') présente une épaisseur dans une plage de 1 à 200 µm, de préférence une plage de 10 à 100 µm, et de façon préférée dans une plage de 20 à 50 µm.
i. Le tracé de contour de la zone de raccordement (3') correspond au moins par secteurs ou en totalité au tracé de contour de la pièce de forme (2), dans une vue sur le côté supérieur (1a) de la plaque de circuit imprimé.
j. Dans au moins une région entre la zone de raccordement (3') et la pièce de forme (2), de préférence dans une région entre deux zones de contact (6) et/ou dans une région qui entoure une zone de contact (6), est agencée une masse de matériau isolant (4).
k. Plusieurs zones de raccordement (3') sont en liaison mutuelle par l'intermédiaire de la pièce de forme (2), et/ou par l'intermédiaire d'au moins un fil conducteur, et/ou par l'intermédiaire d'au moins une piste conductrice obtenue par gravure.

7. Plaque de circuit imprimé (1) selon l'une au moins des revendications précédentes, **caractérisée en ce que** sur la plaque de circuit imprimé (1) est agencée de l'électronique de commande et/ou de l'électronique de puissance.

8. Procédé de fabrication d'une plaque de circuit imprimé (1), de préférence une plaque de circuit imprimé (1) selon l'une au moins des revendications précédentes, comprenant les étapes suivantes :
a. fourniture et préparation d'une pièce de forme (2) en un matériau électriquement conducteur ;
b. mise en contact de la pièce de forme (2) avec une feuille (3) électriquement conductrice, au niveau d'au moins une zone de contact (6) ;
c. application d'une couche de recouvrement (4) sur le côté (3b) de la feuille (3), qui contacte la pièce de forme (2) ; et
d. usinage d'au moins une zone de raccordement (3') par enlèvement de matière dans la feuille.

9. Procédé de fabrication d'une plaque de circuit imprimé (1) selon l'une au moins des revendications précédentes, **caractérisé en ce que** le procédé satisfait à au moins une des exigences suivantes :
a. La fourniture et la préparation de la pièce de forme (2) sont effectuées par sectionnement de la pièce de forme (2) hors d'une pièce (5) en forme de plaque, de préférence par découpage à la matrice, érosion ou découpage, de préférence par découpage au jet d'eau.
b. La mise en contact de la pièce de forme (2) avec la feuille (3) électriquement conductrice au niveau de ladite au moins une zone de contact (6), est effectuée par soudage, bonding, brasage ou collage conducteur, une masse de matériau isolant (4) étant agencée au préalable dans au moins une région entre la feuille (3) et la pièce de forme (2), de préférence dans une région entre deux zones de contact (6) et/ou dans une région qui entoure au moins une zone de contact (6), la masse de matériau isolant (4) étant de manière particulièrement préférée appliquée sur la pièce de forme (2).
c. L'application d'une couche de recouvrement (4) sur le côté (3b) de la feuille (3), qui vient contacter la pièce de forme (2), est effectuée par pressage du côté (3b) de la feuille (3) avec un pré-imprégné ou prépreg de masse de matériau isolant.
d. L'usinage d'au moins une zone de raccordement (3') dans la feuille est effectué par gravure.
